# EUROPÄISCHE PATENTSCHRIFT

(11) **EP 0 902 973 B1**
(45) Veröffentlichungstag und Bekanntmachung des Hinweises auf die Patenterteilung: **17.10.2001**
(21) Anmeldenummer: 97923818.5
(22) Anmeldetag: 14.05.1997
(51) Int. Cl.: H01L 23/498, G06K 19/077

(54) **TRÄGERELEMENT FÜR EINEN HALBLEITERCHIP**
SUBSTRATE FOR A SEMICONDUCTOR CHIP
SUBSTRAT POUR PUCE DE SEMICONDUCTEUR

(30) Priorität: 17.05.1996 DE 19620025; 03.09.1996 DE 19635732
(43) Veröffentlichungstag der Anmeldung: 24.03.1999
(73) Patentinhaber: Infineon Technologies AG, 81669 München (DE)
(72) Erfinder: HOUDEAU, Detlef, D-84085 Langquaid (DE); HUBER, Michael, D-93152 Nittendorf (DE); ROHDE, Volker, D-85661 Forstinning (DE); SCHEUENPFLUG, Richard, D-93161 Sinzing (DE); STAMPKA, Peter, D-92421 Schwandorf (DE)
(74) Vertreter: Zedlitz, Peter, Dipl.-Inf.
(86) Internationale Anmeldenummer: DE9700977
(87) Internationale Veröffentlichungsnummer: WO9744823

(56) Entgegenhaltungen:
- EP-A- 0 226 480
- EP-A- 0 321 327
- EP-A- 0 599 194
- DE-A- 3 046 192
- DE-A- 3 809 005
- DE-A- 4 202 265
- FR-A- 2 617 668
- FR-A- 2 684 236

## Beschreibung

Die Erfindung betrifft ein Trägerelement für einen Hälbleiterchip, insbesondere zum Einbau in Chipkarten, bei dem eine metallische Folie auf eine nicht-leitende Folie laminiert und derart strukturiert ist, daß zwei parallele, sich in der Richtung entgegengesetzter Hauptränder des Trägerelementes erstreckende Reihen von Kontaktflächen gebildet sind, und der Halbleiterchip auf der der metallischen Folie entgegengesetzten Seite der nicht-leitenden Folie angeordnet und durch Ausnehmungen in der nicht-leitenden Folie hindurch elektrisch mit den Kontaktflächen verbunden ist.

Solche Trägerelemente sind beispielsweise aus der DE 34 24 241 C2 bekannt und werden in großem Umfang in Chipkarten eingesetzt. Zu ihrer Herstellung wird eine nicht-leitende Folie, die heute bevorzugt aus glasfaserverstärktem Epoxidharz besteht, mit einer leitenden, vorzugsweise aus oberflächenveredeltem Kupfer bestehenden Folie kaschiert. In diese leitende Folie werden Strukturen geätzt, die voneinander isolierte Kontaktflächen bilden, die in zwei zueinander parallelen Reihen an den Längsseiten einer mittleren Fläche angeordnet sind. Meistens ist eine der äußeren Kontaktflächen einstückig mit der mittleren Kontaktfläche ausgebildet. In die nicht-leitende Folie werden vor dem Laminiervorgang Löcher gestanzt, die einen Zugang zu den Kontaktflächen ermöglichen, um einen Halbleiterchip elektrisch mit den Kontaktflächen verbinden zu können, so daß dieser über die Kontaktflächen von einem Lesegerät kontaktiert werden kann. Es kann auch eine zentrale Stanzung zur Aufnahme des Halbleiterchips vorgesehen sein, wie dies beispielsweise in der DE 34 24 241 C2 der Fall ist, um die Gesamthöhe der Anordnung Trägerelement - Chip zu verringern.

Die bekannten Trägerelemente haben heute zumeist eine etwa rechteckige Grundfläche, wobei die zwei Reihen von Kontaktflächen entlang zweier entgegengesetzter Ränder des Trägerelementes verlaufen.

Trägerelemente der oben beschriebenen Art sind auch aus der FR-A-2617668 und der FR-A-2684236 bekannt. Bei den dortigen Trägerelementen sind die Kontaktflächen mit schmalen Leiterbahnen verbunden, die zu einem gemeinsamen Anschluß führen, um auf einfache Weise eine galvanische Oberflächenveredelung der Kontaktflächen durchführen zu können.

Halbleiterchips für Chipkarten erfüllten früher fast ausschließlich spezielle Speicherfunktionen und waren aufgrund ihres seriellen Dateneingangs nur für die Verwendung in Chipkarten geeignet. Mit der zunehmenden Verbreitung von Chipkarten mit Mikroprozessorfunktionen wurden die hierfür verwendeten Halbleiterchips jedoch allgemeiner verwendbar, da Mikroprozessoren mit seriellem Eingang insbesondere solche mit speziellem Koprozessoren auch Verwendung finden, wenn sie nicht in einer Chipkarte verpackt sind. Sie können beispielsweise auch in PCMCIA-Karten eingebaut werden oder allgemein auf Platinen eine Anwendung finden.

Die heute bevorzugte Verbindungstechnik zwischen Halbleiterchip und einer Platine ist Löten entsprechend der SMD-Technologie (Surface Mounted Device). Hierbei wird eine Lötpaste mittels Siebdruck auf die Platine gebracht und dann die Halbleiterchips, die als SMDs gehäust sind, darauf positioniert. Anschließend wird die Platine in einen Ofen gebracht, um das Lot aufzuschmelzen und hierdurch eine Verbindung zwischen der Platine und dem Halbleiterchip herzustellen.

SMD-fähige Chipgehäuse haben speziell geformte Anschlüsse, die eine automatische Bestückung und einen ebenfalls automatischen Lötvorgang erlauben. Die Lötverbindung muß dabei zuverlässig sein und an definierten Stellen zustande kommen, ohne daß das Lot zerfließt und sich dadurch Kurzschlüsse ergeben bzw. kein guter Kontakt zustande kommt.

Im Gegensatz dazu haben die heutigen Trägerelemente für Chipkarten relativ großflächige Kontakte, die in erster Linie dazu dienen, einen sicheren Kontakt zu Abtastspitzen eines Lesegerätes herzustellen. Insbesondere ist durch den ISO-Standard ISO 7816 festgelegt, welche Mindestgröße und Lage die Kontaktflächen haben müssen.

Es ist also für unterschiedliche Anwendungsfälle nötig, verschiedene Gehäuse bzw. Chipträger vorzusehen, was zu einer Erhöhung der Herstellungskosten aufgrund verschiedener Fertigungsprozesse, Logistik, Materialien usw. führt.

Aus der CH 654 143 A5 ist es zwar bekannt, ein Trägerelement für Chipkarten auch für andere Montageweise, beispielsweise zum Einbau in Hybridschaltungen, vorzusehen. Beim dortigen Trägerelement liegen jedoch die Kontaktflächen für die Chipkartenmontage und einstückig mit diesen ausgebildeten Anschlüsse in verschiedenen Ebenen, so daß eine aufwendige Herstellung vonnöten ist. Außerdem sind die Anschlüsse zur direkten Kontaktierung des Halbleiterchips vorgesehen, so daß sie nicht auch als Lötfahnen verwendet werden können, da hierdurch der Chip beschädigt würde.

Auch die EP 0 311 435 A2 beschreibt ein Trägerelement für Chipkarten aus einem metallkaschierten nicht-leitenden Substrat, bei dem die Metallkaschierung in Kontaktflächen strukturiert ist. Hier sind Anschlüsse bildende Leiterbahnen einstückig mit den Kontaktflächen ausgebildet. Allerdings dienen diese Anschlüsse zur direkten Kontaktierung eines in eine Ausnehmung des Substrats angeordneten Halbleiterchips und ragen zu diesem Zweck in den Bereich der Ausnehmung hinein. Die Anschlüsse können daher auch hier nicht als Lötfahnen verwendet werden.

Die Aufgabe vorliegender Erfindung ist es also, ein Trägerelement für Halbleiterchips anzugeben, das sowohl die für Chipkarten geltenden ISO-Normen erfüllt als auch SMD-Montagefähig ist.

Die Aufgabe ist durch ein Trägerelement gemäß Anspruch 1 gelöst. Vorteilhafte Weiterbildungen sind in den Unteransprüchen angegeben.

Bei der Herstellung eines kupferkaschierten Glasepoxid-Trägerelements werden in erfindungsgemäßer Weise nicht nur Kontaktflächen sondern auch einstückig mit diesem verbundene schmale Leiterbahnen geätzt. Die Kupferfolie soll hierbei eine Dicke von mindestens 35 *µ*m, vorzugsweise etwa 70 *µ*m haben, um einen genügend großen Abstand zwischen der Platine und der nicht-leitenden Kunststoffolie zu gewährleisten, so daß die Gefahr eines elektrischen Kurzschlusses durch die Lötpaste verringert ist. Vorzugsweise ist die nicht-leitende Folie aus Kapton, das genügend temperaturstabil für das SMD-Löten ist. Durch die schmalen, vorzugsweise etwa 0,4 mm breiten und damit der SMD-Norm entsprechenden Leiterbahnen ist eine klar definierte Lötung möglich.

In vorteilhafter Weise verlaufen die Leiterbahnen parallel zueinander und haben dabei vorzugsweise einen Abstand ihrer Mittellinien von etwa 1,27 mm, was ebenfalls SMD-Norm entspricht. Die Leiterbahnen können hierbei sowohl parallel zu den Reihen von Kontaktflächen als auch senkrecht dazu verlaufen. Prinzipiell ist jedoch jede beliebige Richtung möglich.

In vorteilhafter Weiterbildung der Erfindung enden die Leiterbahnen am Rand des Trägerelementes, so daß eine optische Kontrolle der Lötverbindung möglich ist. In weiterer Ausgestaltung weisen sie eine Einschnürung als Fließbarriere auf, so daß die Lötung nur in einem bestimmten Bereich erfolgen kann und dazu gleichzeitig eine gute Verbindung gewährleistet ist.

In weiterer Weiterbildung der Erfindung sind die Leiterbahnen in zwei Gruppen eingeteilt, die an entgegengesetzten Rändern des Trägerelementes enden.

Wenn die Leiterbahnen am Rand des Trägerelementes enden, kann dies dazu führen, daß in der Mitte des Trägerelementes keine Kupferfolie mehr vorhanden ist. Beim elektrischen Kontaktieren des auf der anderen Seite des nicht-leitenden Substrates angeordneten Halbleiterchips mit den Kontaktflächen mittels der Wire-Bond-Technik kann es dazu führen, daß die Substratfolie durchgebogen wird, was zu schlechten Bond-Ergebnissen führen kann. In vorteilhafter Weiterbildung der Erfindung sind deshalb im Mittelbereich des Trägerelementes Flächen der Kupferfolie stehengelassen, die mit den Leiterbahnen und/oder Kontaktflächen verbunden sind, um keine parasitären Kapazitäten zu erzeugen. Diese Flächen fungieren als Stützelemente, um ein Durchbiegen der nicht-leitenden Folie beim Wire-Bonden zu verhindern.

In einer weiteren erfindungsgemäßen Ausgestaltung ist vorgesehen, daß die isolierende Folie wenigstens eine Ausnehmung aufweist, die die für eine permanente Kontaktierung (wie Löten) vorgesehenen Anschlüsse unbedeckt läßt. Somit ist es möglich, von der Seite der isolierenden Folie die Anschlüsse einzusehen, so daß nach einem Löten der Anschlüsse das Lötergebnis optisch kontrollierbar ist. Ohne diese erfindungsgemäße Ausnehmung wäre eine solche optische Kontrolle nicht wirklich möglich, da die elektrisch leitfähige Folie und darin evt. vorhandene Schlitze bzw. Aussparungen in ihrer Gesamtheit von der isolierenden Folie bedeckt wären.

Eine Weiterbildung der Erfindung sieht vor, daß wenigstens einer der Anschlüsse von der isolierenden Folie weggebogen ist. Dies hat den Vorteil, daß während des Lötens ein Kapillar-Effekt des Lotes bei Anschlüssen, die nur einen geringen gegenseitigen Abstand aufweisen, vermieden wird, der zwischen nicht abgewinkelten bzw. weggebogenen Anschlüssen auftreten kann.

Eine andere Weiterbildung der Erfindung sieht vor, daß wenigstens einer der Anschlüsse auf zwei Seiten der Ausnehmung, die günstigerweise gegenüberliegend angeordnet sind, an der isolierenden Folie befestigt ist. Dabei ist die Befestigung des Anschlusses an einer der beiden Seiten der Ausnehmung durchtrennbar, so daß anschließend auch dieser Anschluß von der isolierenden Folie wegbiegbar ist. Durch die beidseitige Fixierung der Anschlüsse wird verhindert, daß diese in Folge einer Handhabung oder eines Transports des Trägerelementes ungewollt verbogen bzw. beschädigt werden. Andererseits ist durch einseitiges Durchtrennen der Befestigung an der isolierenden Folie das vorteilhafte Wegbiegen des Anschlusses vor einem Löten trotzdem möglich.

Die Erfindung soll nachfolgend anhand von Ausführungsbeispielen mit Hilfe von Figuren näher erläutert werden. Dabei zeigen
- Figur 1: eine perspektivische Darstellung der Rück- und Vorderansicht eines erfindungsgemäßen Trägerelementes,
- Figur 2: eine Draufsicht auf das Trägerelement gemäß Figur 1 und
- Figur 3: eine weitere Variante eines erfindungsgemäßen Trägerelementes.
- Figur 4: ein erfindungsgemäßes Trägerelement von der Seite der elektrisch leitfähigen Folie,
- Figur 5: das Trägerelement aus Figur 4 von der entgegengesetzten Seite, auf der sich die elektrisch isolierende Folie befindet,
- Figur 6: eine Querschnittdarstellung des Trägerelements aus Figur 4, nachdem darauf ein Chip mit Umhüllung befestigt worden ist und die Anschlüsse von der isolierenden Folie weggebogen worden sind und
- Figur 7: das Trägerelement aus Figur 6 in der Draufsicht.

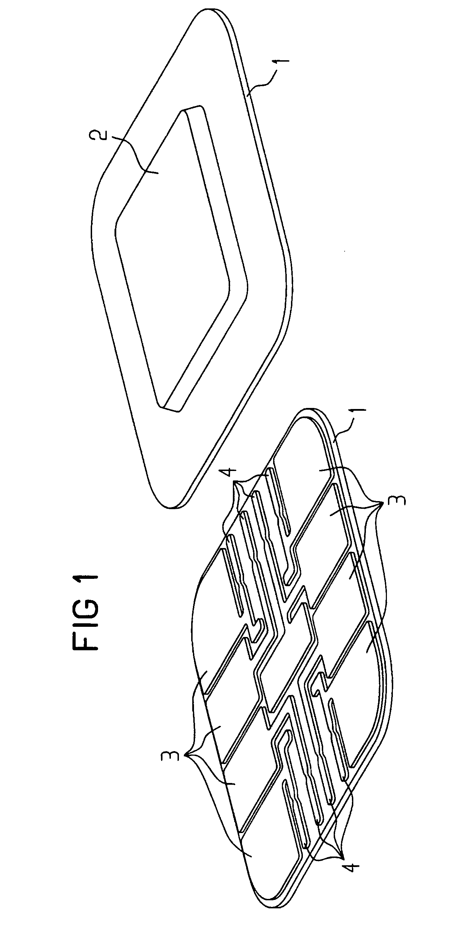

Figur 1 zeigt ein erfindungsgemäßes Trägerelement in perspektivischer Darstellung von der Ober- und der Unterseite. In der rechten Bildhälfte ist die Oberseite dargestellt, die ein nicht-leitendes Substrat 1 aus einem möglichst temperaturbeständigen Kunststoff wie beispielsweise Kapton zeigt. Auf dem Substrat 1 ist ein Kunststoffgehäuse 2 angeordnet, in dessen Innerem ein nicht dargestellter Halbleiterchip ist. Das Kunststoffgehäuse 2 kann mittels einer Spritzform aber auch durch Gießen aufgebracht werden. Im letzteren Fall kann ein stützender Rahmen auf dem Substrat vorgesehen werden.

Im linken Teil der Figur 1 ist die Unterseite des Trägerelementes dargestellt, die die Kontaktflächen 3 sowie die damit einstückig verbundenen Leiterbahnen 4 zeigt.

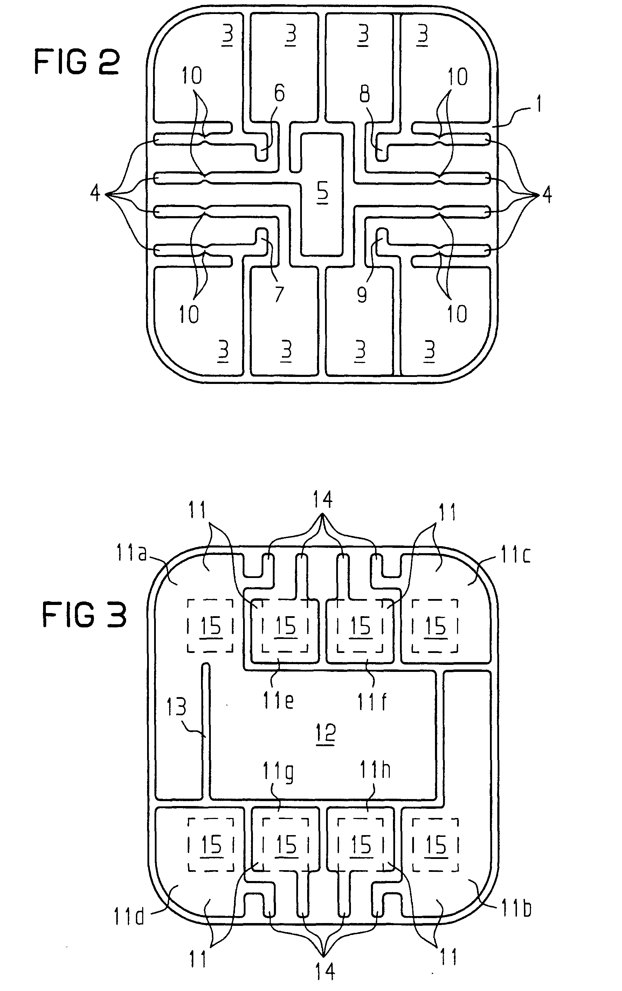

In Figur 2 ist diese Unterseite in Draufsicht gezeigt. Die Kontaktflächen 3 verlaufen in zwei parallelen Reihen entlang zweier entgegengesetzter Ränder des Trägerelementes. Ihre Flächen bedecken dabei die von einem Lesegerät zu kontaktierenden Bereiche deren Größe und Lage durch die ISO-Norm ISO 7816 definiert sind.

Zwischen den zwei Reihen von Kontaktflächen 3 verlaufen parallel hierzu Leiterbahnen 4, die in zwei Gruppen unterteilt sind, wobei jede der Leiterbahnen 4 mit je einem der Kontaktflächen 3 verbunden ist. Die beiden Gruppen enden dabei an entgegengesetzten Rändern des Trägerelementes, so daß zwischen den Mittellinien der Leiterbahnen 4 ein Abstand von etwa 1,27 mm gelassen werden kann, um die Norm für SMD-Löten zu erfüllen. Die Leiterbahnen 4 haben dabei zumindest an ihren Enden, wo die Lötung stattfindet, eine Breite von etwa 0,4 mm.

Beim in Figur 2 gezeigten Trägerelement haben die Leiterbahnen 4 eine konstante Breite. Dadurch würden sich in der Mitte des Trägerelementes und in den Bereichen, wo die Ecken eines auf der gegenüberliegenden Seite des Trägerelementes angeordneten Halbleiterchips zu liegen kommen, Bereich ergeben, an denen die Kupferfolie weggeätzt ist. Dadurch ergibt sich das Problem, daß beim Wire-Bonden des Chips, also bei dessen elektrischen Verbinden mit den Kontaktflächen, sich das nicht-leitende Substrat durchbiegen kann. Aus diesem Grund sind in vorteilhafter Weiterbildung der Erfindung Kupferbereiche 5, 6, 7, 8, 9 stehengelassen worden, die einstückig mit einigen der Leiterbahnen 4 verbunden sind, um parasitäre Kapazitäten zu vermeiden. Prinzipiell könnten aber auch die Leiterbahnen 4 an ihren mit den Kontaktflächen 3 verbundenen Enden breiter ausgebildet werden.

Die Leiterbahnen 4 weisen nahe ihrer freien Enden Einschnürungen 10 auf, die als Fließbarrieren für das Lot wirken. Dadurch kann ein noch genaueres Löten erfolgen.

Die Leiterbahnen 4 sind in der Ausführungsform gemäß Figur 2 an den Rand des Trägerelementes geführt. Sie könnten aber ebenso in der Mitte des Trägerelementes enden. Dann wäre aber keine optische Kontrolle der Lötung mehr möglich.

In Figur 3 ist eine weitere Ausführungsform eines erfindungsgemäßen Trägerelementes gezeigt. Die Kontaktflächen 11 verlaufen hier ebenfalls in zwei parallelen Reihen, jedoch entlang einer mittleren Fläche 12, die einstückig mit einem der Eckkontaktflächen 11a ausgebildet ist. Der Verbund aus mittlerer Fläche 12 und Eckkontaktfläche 11a weist einen Schlitz 13 auf, der etwa so lang ist, wie die mittlere Fläche 12 breit ist. Er verläuft parallel zum Rand des Trägerelementes in einem Abstand, der etwa der Bereite eines Klebefilmes entspricht, mit dem das Trägerelement in eine Plastikkarte eingeklebt wird. Es wird hierzu ein Heißklebeverfahren verwendet, d. h. ein heißer Stempel drückt das Trägerelement für eine bestimmte Zeit auf die Karte, bis der Klebefilm geschmolzen ist. Der Schlitz 13 verhindert, daß die Wärme des Stempels über die Kupferfolie zum Halbleiterchip, der im Bereich der Fläche 12 aufgebracht wird, gelangt und diesen möglicherweise schädigt.

Aus demselben Grund reicht die mittlere Fläche 12 auch nicht bis zum entgegengesetzten Rand des Trägerelementes. Statt dessen ist eine der dortigen Eckkontaktflächen 11b entlang des dortigen Trägerelementrandes verlängert ausgebildet.

Die erfindungsgemäßen, zum SMD-Löten dienenden Leiterbahnen 14 verlaufen bei diesem Ausführungsbeispiel senkrecht zur Richtung der Kontaktflächenreihen und befinden sich zwischen den Eckkontaktflächen 11a,...11d. Aus diesem Grund reichen die mittleren Kontaktflächen 11e,...11h nicht bis zum Rand des Trägerelementes sondern nur bis zur - strichliert angedeuteten - durch die ISO-Norm ISO 7816 vorgegebenen Linie.

Die Mindestgröße und Lage der Kontaktfläche 11 ist durch strichlierte Bereich 15 dargestellt.

Die Leiterbahnen 14 sind hier wesentlich kürzer als beim Ausführungsbeispiel nach Figur 2, erlauben aber trotzdem ein sicheres Löten. Auch hier können Einschnürungen als Fließbarriere vorgesehen werden. Dies ist in Figur 3 jedoch nicht dargestellt. Auch im Ausführungsbeispiel nach Figur 3 entsprechen Breite und Abstand der Leiterbahnen der Norm SMD-Löten.

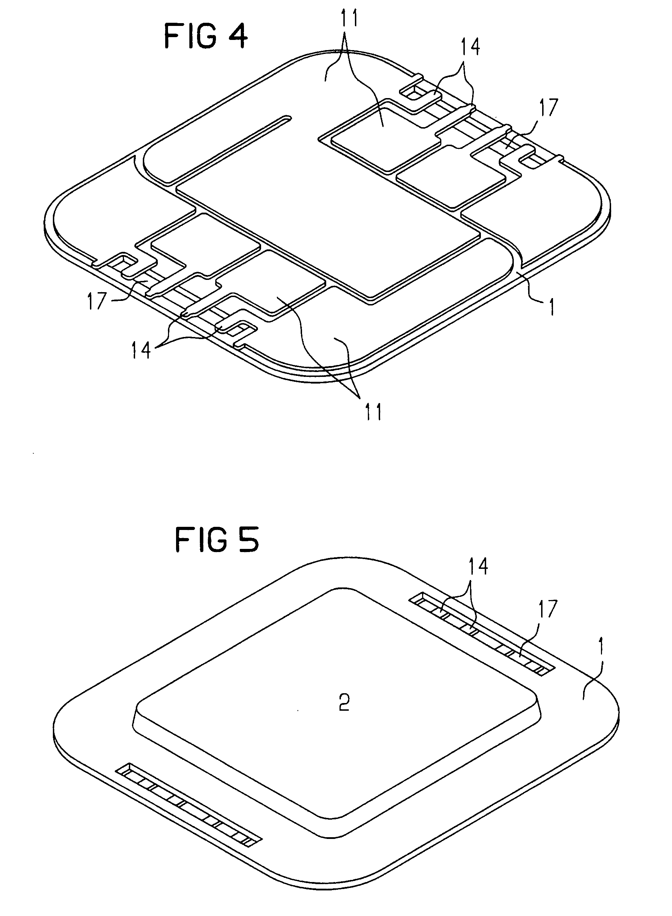

Figur 4 zeigt eine Weiterbildung des erfindungsgemäßen Trägerelementes, wie es bereits in Figur 3 dargestellt. Dabei sind auch hier die Kontaktflächen 11 für eine lösbare Kontaktierung des Trägerelementes und die Anschlüsse 14 für eine permanente Kontaktierung des Trägerelementes vorgesehen. Eine lösbare Kontaktierung über die Kontaktflächen 11 liegt vor, wenn das Trägerelement in eine Chipkarte eingesetzt wird, die dann für die Kontaktierung in entsprechende Lesegeräte einschiebbar und aus diesen anschließend wieder entnehmbar ist. Um eine permanente Kontaktierung handelt es sich, wenn das Trägerelement stattdessen beispielsweise auf eine Platine gelötet wird.

Das Trägerelement weist bei diesem Ausführungsbeispiel zwei Ausnehmungen 17 in der isolierenden Folie 1 auf, die die für die permanente Kontaktierung vorgesehenen Anschlüsse 14 von der isolierenden Folie 1 unbedeckt lassen. Da sich die Ausnehmungen 17 beabstandet zum äußeren Rand der isolierenden Folie 1 befinden, ist es, wie in Figur 4 gezeigt, möglich, daß die Anschlüsse 14 über die Ausnehmungen 17 hinausragen und somit auf zwei gegenüberliegenden Seiten der Ausnehmungen 17 durch Kleben an der isolierenden Folie 1 befestigt sind. Diese beidseitige Fixierung der Anschlüsse 14 hat den Vorteil, daß sie trotz ihrer filigranen Abmessungen vor Beschädigungen geschützt sind. Insgesamt wird hierdurch die Stabilität des Trägerelementes erhöht.

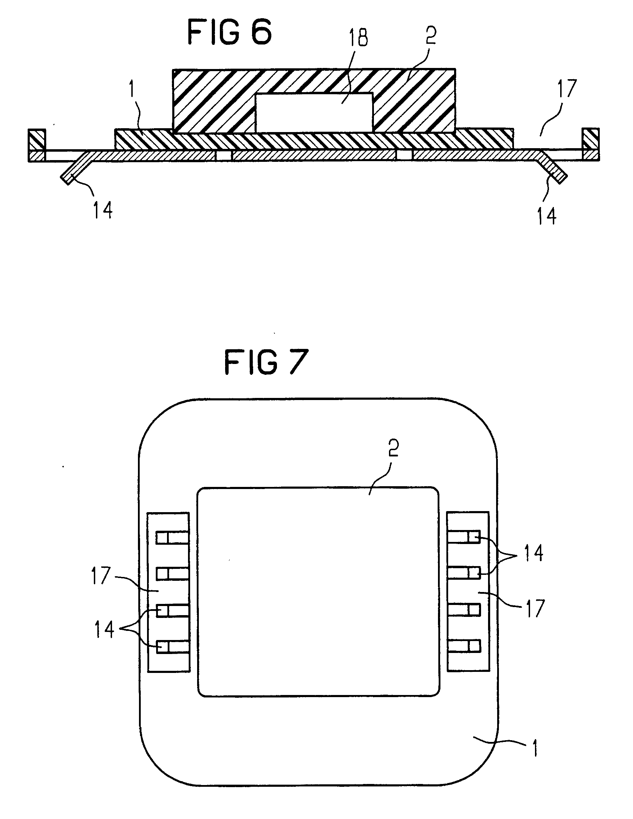

Figur 5 zeigt das Trägerelement aus Figur 4 von der anderen Seite. In Figur 5 ist das Trägerelement bereits mit einem von einer Umhüllung umgebenen Halbleiterchip versehen. Dabei ist nur die üblicherweise aus einem Duroplasten hergestellte Umhüllung 2 und nicht der innerhalb dieser angeordnete Chip selbst sichtbar. Auch die elektrischen Verbindungen zwischen den Anschlüssen des Chips und den Kontaktflächen 11 bzw. Anschlüssen 14 sind von der Chipumhüllung 2 verdeckt.

Die Herstellung des Trägerelementes kann in folgender Weise geschehen:
1. Zur Herstellung der elektrisch isolierenden Folie 1 eignet sich beispielsweise Epoxidharz, Polyesterfolie oder Kapton. Sie weist eine Dicke zwischen 60 und 180*µ*m auf. Durch Stanzung werden in der isolierenden Folie 1 Löcher erzeugt, mittels derer später die elektrische Verbindung zwischen dem Chip und den Kontaktflächen 11 bzw. den Anschlüssen 14 bewerkstelligbar ist. Mit demselben Stanzvorgang sind auch die erfindungsgemäßen Ausnehmungen 17 erzeugbar.
2. Herstellung der elektrisch leitfähigen Folie, günstigerweise aus Kupfer, welches 35 bis 70*µ*m dick ist.
3. Nun können die Kontaktflächen 11 und die Anschlüsse 14 in der leitfähigen Folie entweder durch Stanzen hergestellt werden, woraufhin ein Zusammenlaminieren der beiden Folien folgt oder vor der Strukturierung der leitfähigen Folie erfolgt ein Zusammenlaminieren der beiden Folien, woraufhin die Strukturierung der leitfähigen Folie 4 mittels Fotolackbeschichtung und nachfolgendem Belichten und Ätzen erfolgt.
4. Beschichten der leitfähigen Folie mit Nickel (zur Herstellung einer Diffusionsbarriere, einer Verbesserung der Bondfähigkeit und Erhöhung der tribologischen Eigenschaften) und mit Gold (um der Korrosion vorzubeugen und aus optischen Gründen).

Figur 6 zeigt das Trägerelement aus den Figuren 4 und 5 in einer Querschnittdarstellung und Figur 7 in einer Draufsicht, wobei die Darstellungen nicht maßstäblich sind. Bei dem Trägerelement in Figur 6 wurden die Anschlüsse 14 - beispielsweise durch Stanzen - jeweils auf einer Seite der Ausnehmungen 17 von ihrer Befestigung mit der isolierenden Folie 1 getrennt und anschließend nach unten von der isolierenden Folie 1 weggebogen bzw. abgewinkelt. Die elektrische Verbindung zwischen den Anschlüssen 14 und dem Chip 18 bleiben natürlich über die zweite Befestigung der Anschlüsse 14 erhalten.

Das Abwinkeln der Anschlüsse 14 hat den Vorteil, daß ein Kapillareffekt für das Lot aufgrund des relativ geringen Abstandes zwischen benachbarten Anschlüssen 14 vermieden wird. Entscheidend hierfür ist der durch das erfindungsgemäße Wegbiegen der Anschlüsse 14 erreichte vertikale Abstand zwischen Lotoberfläche und Unterseite der isolierenden Folie 1.

Den Figuren und insbesondere Figur 6 ist deutlich zu entnehmen, daß durch die erfindungsgemäßen Ausnehmungen 17 in der isolierenden Folie 1 bei einem Löten der Anschlüsse 14 zur Herstellung einer permanenten Kontaktierung des Trägerelementes zum einen ein direkter Zugang von oberhalb der isolierenden Folie 1 zur Lötstelle vorhanden ist und andererseits nach Abschluß des Lötvorganges dessen Ergebnis optisch kontrolliert werden kann. Dies ist besonders vorteilhaft, da es bei der Herstellung von Trägerelementen aufgrund der mechanischen Spannung durch starken Schrumpf des Materials der Chipumhüllung zu starken Unebenheiten der elektrisch leitfähigen Folie kommen kann. Dies kann zu Kurzschlüssen zwischen den Kontaktflächen 11 oder den Anschlüssen 14 oder zu weiteren Lötfehlern, wie ungenügende Benetzung, Lunker usw. führen.

Anders als in Figur 6 dargestellt, ist es natürlich auch möglich, die Anschlüsse 14 nicht von der isolierenden Folie 1 wegzubiegen, wodurch ein Ausstanzen der Anschlüsse 14 auf einer Seite der Ausnehmung 17 unnötig wird. Hierdurch verzichtet man zwar auf den Vorteil der Vermeidung eines Kapillareffektes für das Lot, spart jedoch Fertigungsschritte bei gleichzeitigem Erhalt des Vorteils der optischen Kontrollierbarkeit der permanenten Kontaktierung und der sicheren Fixierung der Anschlüsse 14 an der isolierenden Folie 1.

Bei anderen Ausführungsbeispielen der Erfindung ist es auch möglich, daß die Ausnehmungen 17 direkt am Rand der isolierenden Folie 1 angeordnet sind. In diesem Fall oder wenn die Anschlüsse 14 bei den abgebildeten Ausführungsbeispielen nicht an den außen liegenden Seiten der Ausnehmungen 17 befestigt sind (indem sie dort entweder nicht verklebt sind oder gar nicht über die Ausnehmung 17 hinausragen) ist es besonders einfach möglich, ein Wegbiegen der Anschlüsse 14 von der isolierenden Folie 1 durchzuführen, da hierzu kein Stanzvorgang erforderlich ist.

Es sind selbstverständlich auch Ausführungsformen der Erfindung möglich, bei der eine andere Anzahl von Ausnehmungen 17 als bei den abgebildeten Trägerelementen vorliegt. In Abwandlung der abgebildeten Gegenstände kann jede der Ausnehmungen 17 beispielsweise zwischen den einzelnen Anschlüssen 14 noch einmal unterteilt sein. Je nach Anordnung der Anschlüsse 14 muß eine Anpassung der Form und Anordnung der Ausnehmungen 17 erfolgen.

Die Erfindung eignet sich insbesondere für eine permanente Kontaktierung des Trägerelementes über die Anschlüsse in SMD-Technologie. Es ist jedoch auch möglich, die weggebogenen Anschlüsse auf herkömmliche Weise in in einer Platine befindliche Löcher zu stecken und dort zu verlöten. Auch dann ermöglichen die erfindungsgemäßen Ausnehmungen eine optische Kontrolle des Lötergebnisses.

Für die Herstellung der permanenten Kontaktierung der Anschlüsse 14 kommt außer Löten auch ein Kleben mittels eines leitfähigen Klebers in Betracht.

Durch die erfindungsgemäße Ausbildung der Kontatkseite eines metallkaschierten Kunststoffsubstrat-Trägerelementes mit einstückig mit den Kontaktflächen ausgebildeten Leiterbahnen können die Trägerelemente sowohl in Chipkarten eingebaut als auch auf Platinen gelötet werden.

## Patentansprüche

1. Trägerelement für einen Halbleiterchip (18), insbesondere zum Einbau in Chipkarten, bei dem eine metallische Folie auf eine nicht-leitende Folie (1) laminiert und derart strukturiert ist, daß zwei parallele, sich in der Richtung entgegengesetzter Hauptränder des Trägerelementes erstreckende Reihen von Kontaktflächen (3; 11) gebildet sind,
und der Halbleiterchip auf der der metallischen Folie entgegengesetzten Seite der nicht-leitenden Folie angeordnet und durch Ausnehmungen in der nicht-leitenden Folie hindurch elektrisch mit den Kontaktflächen verbunden ist,
**dadurch gekennzeichnet,**
**daß** jede der Kontaktflächen (3; 11) mit einer im Verhältnis zur Abmessung einer Kontaktfläche schmalen, aus der metallischen Folie entstandenen und in einer Ebene mit dieser verlaufenden, Anschlüsse (4; 14) bildenden Leiterbahn einstückig verbunden ist, wobei die Anschlüsse (4;14) in ihren Abmessungen und Abständen zueinander der ISO-Norm für SMD-Löten entsprechen.

2. Trägerelement nach Anspruch 1,
**dadurch gekennzeichnet,**
**daß** der Halbbleiterchip in einer Ausnehmung der nicht-leitenden Folie angeordnet ist, die über ihre gesamte Ausdehnung durch die metallische Folie abgedeckt ist.

3. Trägerelement nach Anspruch 1 oder 2,
**dadurch gekennzeichnet,**
**daß** die Leiterbahnen (4; 14) zum Rand des Trägerelementes führen.

4. Trägerelement nach einem der Ansprüche 1 bis 3,
**dadurch gekennzeichnet,**
**daß** die Leiterbahnen (4) jeweils eine Einschnürung (10) aufweisen.

5. Trägerelement nach einem der Ansprüche 1 bis 4,
**dadurch gekennzeichnet,**
**daß** die Leiterbahnen (4; 14) in zwei Gruppen aufgeteilt sind, wobei die Leiterbahnen (4; 14) einer jeweiligen Gruppe an entgegengesetzten Rändern des Trägerelementes enden.

6. Trägerelement nach einem der Ansprüche 1 bis 5,
**dadurch gekennzeichnet,**
**daß** die Leiterbahnen (14) an den Haupträndern des Trägerelementes enden.

7. Trägerelement nach einem der Ansprüche 1 bis 5,
**dadurch gekennzeichnet,**
**daß** die Leiterbahnen (4) an den senkrecht zu den Haupträndern verlaufenden Rändern des Trägerelementes enden.

8. Trägerelement nach einem der vorherigen Ansprüche,
**dadurch gekennzeichnet,**
**daß** zumindest eine der Leiterbahnen (4) im Bereich der Mitte des Trägerelementes eine Anformung aufweist.

9. Trägerelement nach Anspruch 8,
**dadurch gekennzeichnet,**
**daß** zumindest eine der Anformungen breiter als die Leiterbahnen (4) ist.

10. Trägerelement nach einem der vorherigen Ansprüche,
**dadurch gekennzeichnet,**
**daß** die isolierende Folie (1) wenigstens eine Ausnehmung (17) aufweist, die die für die permanente Kontaktierung vorgesehenen Teile der Anschlüsse (14) unbedeckt läßt.

11. Trägerelement nach Anspruch 10,
**dadurch gekennzeichnet,**
**daß** wenigstens einer der Anschlüsse (14) von der isolierenden Folie (1) weggebogen ist.

12. Trägerelement nach Anspruch 10,
**dadurch gekennzeichnet,**
**daß** wenigstens einer der Anschlüsse (14) auf zwei Seiten der Ausnehmung (17) an der isolierenden Folie (1) befestigt ist.

## Claims

1. Carrier element for a semiconductor chip (18), in particular for incorporation in smart cards, in which a metallic sheet is laminated onto- a non-conductive sheet (1) and structured to form two parallel rows of contact areas (3; 11) extending in the direction of opposite main edges of the carrier element,
and the semiconductor chip is arranged on that side of the non-conductive sheet which is opposite to the metallic sheet, and is electrically connected to the contact areas through cutouts in the non-conductive sheet, **characterized in that** each of the contact areas (3; 11) is connected in one piece to a conductor track which is narrow in relation to the dimension of a contact area, is produced from the metallic sheet, runs in one plane with the latter and forms terminals (4; 14), the dimensions and mutual spacings of the terminals (4; 14) corresponding to the ISO standard for SMD soldering.

2. Carrier element according to Claim 1, **characterized in that** the semiconductor chip is arranged in a cutout in the non-conductive sheet which is covered over its entire extent by the metallic sheet.

3. Carrier element according to Claim 1 or 2, **characterized in that** the conductor tracks (4; 14) lead to the edge of the carrier element.

4. Carrier element according to one of Claims 1 to 3, **characterized in that** the conductor tracks (4) each have a constriction (10).

5. Carrier element according to one of Claims 1 to 4, **characterized in that** the conductor tracks (4; 14) are divided into two groups, the conductor tracks (4; 14) of a respective group ending at opposite edges of the carrier element.

6. Carrier element according to one of Claims 1 to 5, **characterized in that** the conductor tracks (14) end at the main edges of the carrier element.

7. Carrier element according to one of Claims 1 to 5, **characterized in that** the conductor tracks (4) end at those edges of the carrier element which run perpendicular to the main edges.

8. Carrier element according to one of the preceding claims, **characterized in that** at least one of the conductor tracks (4) has an integrally formed. portion in the region of the centre of the carrier element.

9. Carrier element according to Claim 8, **characterized in that** at least one of the integrally formed portions is wider than the conductor tracks (4).

10. Carrier element according to one of the preceding claims, **characterized in that** the insulating sheet (1) has at least one cutout (17), which leaves -those parts of the terminals (14) which are provided for permanent contact-making uncovered.

11. Carrier element according to Claim 10, **characterized in that** at least one of the terminals (14) is bent away from the insulating sheet (1).

12. Carrier element according to Claim 10, **characterized in that** at least one of the terminals (14) is fastened to the insulating sheet (1) on two sides of the cutout (17).

## Revendications

1. Substrat pour une puce (18) à semi-conducteur, destinée notamment à être incorporée dans des cartes à puce, dans lequel une feuille métallique est appliquée sur une feuille (1) non conductrice et est structurée de façon à former deux rangées parallèles de surfaces (3, 11) de contact, s'étendant dans la direction des bords principaux opposés du substrat, et la puce à semi-conducteur est disposée sur la face de la feuille non conductrice qui est opposée à la feuille métallique et est reliée électriquement aux surfaces de contact par des évidements traversant la feuille non conductrice,
**caractérisé**
**en ce que** chacune des surfaces (3, 11) de contact est reliée d'une pièce à une piste conductrice étroite par rapport à la dimension d'une surface de contact, provenant de la feuille métallique, s'étendant dans un plan avec celle-ci et formant des bornes (4, 14), les dimensions des bornes (4, 14) et les intervalles entre elles correspondant à la norme ISO pour des brasures SMD.

2. Substrat suivant la revendication 1,
**caractérisé**
**en ce que** la puce à semi-conducteur est disposée dans un évidement de la feuille non conductrice, qui est recouvert sur toute son étendue par la feuille métallique.

3. Substrat suivant la revendication 1 ou 2,
**caractérisé**
**en ce que** les pistes (4, 14) conductrices vont jusqu'au bord du substrat.

4. Substrat suivant l'une des revendications 1 à 3,
**caractérisé**
**en ce que** les pistes (4) conductrices comportent chacune un étranglement (10).

5. Substrat suivant l'une des revendications 1 à 4,
**caractérisé**
**en ce que** les pistes (4, 14) conductrices sont subdivisées en deux groupes, les pistes (4, 14) conductrices d'un groupe se terminant aux bords opposés du substrat.

6. Substrat suivant l'une des revendications 1 à 5,
**caractérisé**
**en ce que** les pistes (14) conductrices se terminent sur les bords principaux du substrat.

7. Substrat suivant l'une des revendications 1 à 5,
**caractérisé**
**en ce que** les pistes (4) conductrices se terminent aux bords du substrat s'étendant perpendiculairement aux bords principaux.

8. Substrat suivant l'une des revendications précédentes,
**caractérisé**
**en ce qu'**au moins l'une des pistes (4) conductrices comporte en la région du milieu du support une conformation.

9. Substrat suivant la revendication 8,
**caractérisé**
**en ce qu'**au moins l'une des conformations est plus large que les pistes (4) conductrices.

10. Substrat suivant l'une des revendications précédentes,
**caractérisé**
**en ce que** la feuille (1) isolante comporte au moins un évidement (17) qui laisse à découvert les parties des bornes (14) qui sont prévues pour le contact permanent.

11. Substrat suivant la revendication 10,
**caractérisé**
**en ce qu'**au moins l'une des bornes (14) s'éloigne de manière incurvée de la feuille (1) isolante.

12. Substrat suivant la revendication 10,
**caractérisé**
**en ce que** la au moins une des bornes (14) est fixée sur deux côtés de l'évidement (17) à la feuille (1) isolante.
